# EUROPEAN PATENT SPECIFICATION

(11) **EP 4 622 099 B1**
(45) Date of publication and mention of the grant of the patent: **11.11.2026**
(21) Application number: 25164516.4
(22) Date of filing: 18.03.2025
(51) Int. Cl.: H03F 1/32, H03F 3/45, H03F 1/26, H03F 3/187, H03F 3/26, H03F 3/21

(54) **AMPLIFIER CIRCUIT AND METHOD FOR AMPLIFYING AN AUDIO SIGNAL**
VERSTÄRKERSCHALTUNG UND VERFAHREN ZUR VERSTÄRKUNG EINES AUDIOSIGNALS
CIRCUIT AMPLIFICATEUR ET PROCÉDÉ D'AMPLIFICATION D'UN SIGNAL AUDIO

(30) Priority: 22.03.2024 IT 202400006415
(43) Date of publication of application: 24.09.2025
(73) Proprietor: Powersoft SpA, 50018 Scandicci (Firenze) (IT)
(72) Inventor: LASTRUCCI, Claudio, 50055 LASTRA A SIGNA (FIRENZE) (IT); BRACCIOTTI, Leonardo, 50025 MONTESPERTOLI (FIRENZE) (IT)
(74) Representative: Conti, Marco

(56) References cited:
- US-A- 2 710 312
- US-A1- 2020 127 620
- CHANG WEI-LING ET AL: "5-6 GHz CMOS low-noise direct conversion receiver using a differential RF VGA with a differential inductor load", 2016 IEEE INTERNATIONAL SYMPOSIUM ON RADIO-FREQUENCY INTEGRATION TECHNOLOGY (RFIT), IEEE, 24 August 2016 (2016-08-24), pages 1 - 3, XP032971163, DOI: 10.1109/RFIT.2016.7578129

## Description

The present invention relates to an amplifier circuit and to a method for amplifying an audio signal.

In the field of audio signal amplifiers, there is a need to minimize the noise and distortion associated with the signal.

Traditionally, the prior art teaches the use of solutions which involve galvanically isolating an input stage of the signal from the amplifying stage of the signal, so as to make the amplifying circuit more robust against external signal noise.

Of the solutions which involve galvanic isolation, one example consists in first digitizing the input signal, decoupling it via an optical transmission system (in particular, a photocoupler) and then reconverting the digital signal into an analog signal to feed it as input to a loudspeaker. Prior to decoupling, this solution uses active electronic components (in particular, operational amplifiers and/or analog-to-digital converters) which need a dedicated electrical power supply. This solution therefore has the disadvantage of necessitating additional isolation of the powered section.

Another solution involves the use of a transformer to galvanically isolate the input stage from the amplifying stage. The magnetic field induced in the transformer is not linear, however, and this produces signal distortions through the transformer. Patent documents US4567443 and US3828269 describe examples for reducing the distortions generated by the transformer. In particular, in document US4567443, the output signal from the differential amplifier is fed to a secondary winding of an additional transformer which is electrically connected to the first transformer.

In document US3828269, on the other hand, the output signal from the differential amplifier is fed to one end of the secondary winding of the transformer itself. This solution, however, tends to increase the sensitivity of the circuit to external nose, which means the transformer must be shielded using noble materials, making the system very expensive.

Also patent documents US2020/127620A1 and US2710312A describe examples of amplifier circuits; however, neither those documents are able to satisfy the market's needs.

This disclosure has for an aim to provide an amplifier circuit and a method for amplifying an audio signal to overcome the above-mentioned disadvantages of the prior art.

In particular, the aim of this disclosure is to provide an amplifier circuit and a method for amplifying an audio signal capable of generating an output signal which is free of noise, free of distortion and galvanically isolated.

Another aim of this invention is to propose an amplifier circuit which is capable of supressing common mode noise. This invention also allows extending the low-frequency response using small transformers.

In addition, this invention provides an amplifier circuit and a method for amplifying an audio signal which can reduce the transformer distortion without using additional shielding.

These aims are fully achieved by the amplifier circuit and method for amplifying an audio signal of this invention, as characterized in the appended claims.

In particular, the amplifier circuit for amplifying an audio signal comprises an input stage. The input stage is responsible for receiving a signal representing the audio signal to be amplified.

The input stage comprises a first pin (which defines a first input node) and a second pin (which defines a second input node). Hereinafter, the terms first input node and second input mode are used as synonyms for the terms first pin and second pin, respectively. The first input node is responsible for receiving a first input signal representing an audio signal. The second input node is responsible for receiving a second input signal representing the audio signal. Preferably, the second input signal is 180° out of phase with the first input signal.

That way, the first input signal and the second input signal constitute a balanced signal.

The amplifier circuit comprises a transformer. The transformer includes a primary winding and a secondary winding. The secondary winding defines (or includes) a first terminal and a second terminal. Preferably, the secondary winding defines (or includes) a middle terminal. The first terminal, the second terminal and the middle terminal may define a first secondary winding and a second secondary winding. To make the first secondary winding and the second secondary winding, two approaches are possible. In a first approach, the first secondary winding and the second secondary winding are (constitute) two distinct windings; in the first approach, the first secondary winding is between the first terminal and the middle terminal, and the second secondary winding is between the middle terminal and the second terminal. In a second approach, there is a single winding between the first terminal and the second terminal (thus, the secondary winding is a single winding) and the middle terminal is defined by a central socket of the secondary winding (that is, of the single winding). Thus, in the second approach, the central socket (that is, the middle terminal) divides the secondary winding into a first secondary winding and a second secondary winding. The first terminal, the second terminal and the middle terminal respectively define a first end, a second end and a central socket. Preferably, the secondary winding defines a central socket. In particular, the central socket is located between the first end and the second end. The central socket may divide the secondary winding into a first secondary winding and a second secondary winding so as to form a double secondary winding.

According to an aspect, the secondary winding may include a first secondary winding and a second secondary winding, where the first secondary winding and the second secondary winding are respective, distinct windings. In this case, the central socket may not be present.

The amplifier circuit comprises a differential amplifier. The differential amplifier includes a first input, a second input and an output. In particular, the first input is electrically connected to the first terminal of the secondary winding by a first connecting branch. The second input is electrically connected to the middle terminal of the secondary winding by a second connecting branch. The output is connected to the second terminal of the secondary winding.

The amplifier circuit comprises an additional transformer. The additional transformer includes an additional primary winding and an additional secondary winding. The additional secondary winding defines (or includes) a first terminal and a second terminal. Preferably, the additional secondary winding defines (or includes) a middle terminal. The first terminal, the second terminal and the middle terminal may define an additional first secondary winding and an additional second secondary winding. To make the additional first secondary winding and the additional second secondary winding, two approaches are possible. In a first approach, the additional first secondary winding and the additional second secondary winding are (constitute) two distinct windings; in the first approach, the additional first secondary winding is between the first terminal and the middle terminal, and the additional second secondary winding is between the middle terminal and the second terminal. In a second approach, there is an additional single winding between the first terminal and the second terminal (thus, the additional secondary winding is a single winding) and the middle terminal is defined by a central socket of the additional secondary winding (that is, of the single winding). Thus, in the second approach, the central socket (that is, the middle terminal) divides the additional secondary winding into an additional first secondary winding and an additional second secondary winding. The first terminal, the second terminal and the middle terminal respectively define a first end, a second end and a central socket. The additional secondary winding defines a first end and a second end. Preferably, the additional secondary winding defines a central socket. In particular, the central socket is located between the first end and the second end of the additional secondary winding. The central socket may divide the additional secondary winding into an additional first secondary winding and an additional second secondary winding so as to form an additional double secondary winding. According to an aspect, the secondary winding may include a first secondary winding and a second secondary winding, where the first secondary winding and the second secondary winding are respective, distinct windings. In this case, the central socket may not be present.

In particular, the primary winding and the additional primary winding are electrically connected (in particular, electrically connected in series) across the first input node and the second input node.

The amplifier circuit comprises an additional differential amplifier. The additional differential amplifier includes a first input, a second input and an output. In particular, the first input is electrically connected to the first terminal of the additional secondary winding of the additional transformer by a first connecting branch. The second input is electrically connected to the middle terminal of the additional secondary winding by a second connecting branch. The output is connected to the second terminal of the additional secondary winding.

Therefore, the differential amplifier and the additional differential amplifier each amplify the voltage difference present across its own inputs, and the output signal powers, that is, is injected into, the second end (that is, the second terminal) of the respective transformer; that way, the voltage difference is cancelled, bringing the induction of the respective transformer core to near zero.

The amplifier circuit comprises an output circuit for receiving as input the output signals from the differential amplifier and from the additional differential amplifier to generate a differential output signal.

In particular, to generate the differential output signal, the output circuit may comprise a differential output amplifier; the differential output amplifier is responsible for receiving as input the output signals from the differential amplifier and from the additional differential amplifier so as to generate a differential output signal. The differential output signal may be generated in other ways, however, such as, for example, with an analog circuit or with a digital circuit (for example, the output signal from the differential amplifier and from the additional differential amplifier might be digitized and processed to obtain the differential output signal).

The output signal from the differential amplifier and the output signal from the additional differential amplifier may be 180° out of phase with each other. The output circuit may be responsible for generating a differential output signal proportional to the difference between the output signal from the differential amplifier and the output signal from the additional differential amplifier. That way, the output signal from the differential amplifier is further cleaned of common mode noise between the output signal from the amplifier and the output signal from the additional amplifier. Thus, the amplifier circuit has the advantage of suppressing the noise caused by the stray capacitance produced between windings of the transformers.

In an example, the primary winding of the transformer and the additional primary winding of the additional transformer are configured to generate a magnetic flux and an opposite, additional magnetic flux. In other words, the primary winding and the additional primary winding are connected in such a way as to have discordant polarity. Therefore, the magnetic flux generated by the primary winding of the transformer and the magnetic flux generated by the additional primary winding of the additional transformer cancel each other out.

Preferably, for both the differential amplifier and the additional differential amplifier, the first input is a non-inverting input and the second input is an inverting input.

For both the differential amplifier and the additional differential amplifier, the first secondary winding and the second secondary winding have concordant polarity. For both the transformer and the additional transformer, the primary winding and the secondary winding may have concordant polarity, that is, additive polarity.

In an example, the transformer and the additional transformer are identical, placed side by side and oriented in the same way, so that an external magnetic flux generates the same current in the transformer and in the additional transformer. In other words, the turns of the windings of the transformer and of the additional transformer must be wound along axes which are parallel to each other, that is to say, the turns of the windings of the transformer and of the additional transformer must be wound on parallel stretches of their cores.

Preferably, the transformer and the additional transformer are located relative to each other at a distance such that an external magnetic flux generates the same current in the transformer and in the additional transformer.

Thus, the transformer and the additional transformer are geometrically arranged relative to each other in such a way that the noise caused by external magnetic fields is suppressed. In other words, the purpose of such an arrangement is that the noise caused by external sources is made common to both of the transformers and removed by the electronic circuit, which is essentially sensitive to signals of differential type.

It is noted that, generally speaking, because the differential amplifier is an active component which draws on an external power source to produce a voltage and current (power) gain, when it acts on the transformer, it makes the transformer more sensitive to external electromagnetic fields; using a double isolation system (a first system comprising the transformer and the amplifier and a second system comprising the additional transformer and the additional amplifier) has the advantage of reducing the noise caused by external electromagnetic fields without having to use expensive shielding systems.

As regards the secondary winding and the additional secondary winding, the inductance of the first secondary winding and the inductance of the second secondary winding may have the same value or different values.

Preferably, the inductance of the first secondary winding is greater than the inductance of the second secondary winding. More preferably, the inductance of the first secondary winding is 100 times greater than the inductance of the second secondary winding. The asymmetry in the inductance values between the first secondary winding and the second secondary winding has the advantage of improving the signal-to-noise ratio, in that it is possible to reduce the impedance of the active cancellation circuit to lower values, reducing the overall thermal noise of the components in play.

In an example, for both the differential amplifier and the additional differential amplifier, the output is connected to the second input by a first impedance.

For both the differential amplifier and the additional differential amplifier, the second connecting branch includes a second impedance, so that the second input can be connected to the middle terminal of the respective secondary winding through the second impedance. For both the differential amplifier and the additional differential amplifier, the output may be connected to the second terminal of the respective secondary winding through a third impedance.

Preferably, the amplifier circuit comprises a ground connection between the second impedance and the middle terminal for both the differential amplifier and the additional differential amplifier.

In an example, the first and/or the second and/or the third impedance comprise a resistive component. The first and/or the second and/or the third impedance may comprise a capacitive component.

Preferably, the transformer and the additional transformer are identical. Preferably, the transformer comprises a core and the additional transformer comprises an additional core which is distinct from the core of the transformer.

In an example, the output circuit comprises a differential output amplifier to generate the balanced differential output signal.

This disclosure also provides a method for amplifying an audio signal. The method comprises a step of receiving an input signal representing an audio signal. Preferably, the method comprises a step of receiving a first input signal representing an audio signal at a first input node of an input stage. Preferably, the method comprises a step of receiving, at a second input node of the input stage, a second input signal, representing the audio signal and being 180° out of phase with the first input signal.

The method comprises a step of providing a transformer including a primary winding and a secondary winding. The secondary winding defines (or includes) a first terminal and a second terminal. Preferably, the secondary winding defines (or includes) a middle terminal. The first terminal, the second terminal and the middle terminal may define a first secondary winding and a second secondary winding. The first terminal, the second terminal and the middle terminal respectively define a first end, a second end and a central socket.

The method comprises a step of providing a differential amplifier, having a first input which is electrically connected to the first terminal of the secondary winding by a first connecting branch, a second input which is electrically connected the middle terminal of the secondary winding by a second connecting branch, and an output which is connected to the second terminal of the secondary winding.

The method comprises a step of providing an additional transformer which includes an additional primary winding and an additional secondary winding.

The secondary winding defines (or includes) a first terminal and a second terminal. Preferably, the additional secondary winding defines (or includes) a middle terminal. The first terminal, the second terminal and the middle terminal may define an additional first secondary winding and an additional second secondary winding. The first terminal, the second terminal and the middle terminal respectively define a first end, a second end and a central socket.

Preferably, the primary winding and the additional primary winding are electrically connected in series across the first input node and the second input node.

The method comprises a step of providing an additional differential amplifier, having a first input which is electrically connected to the first terminal of the additional secondary winding by a first connecting branch, a second input which is electrically connected to the middle terminal of the additional secondary winding by a second connecting branch, and an output which is connected to the second terminal of the additional secondary winding of the additional transformer.

Preferably, the method comprises a step of generating a balanced differential output signal from the output signals from the differential amplifier and from the additional differential amplifier to make the balanced differential output signal available to an output stage.

In an example, the method comprises a step, via the primary winding of the transformer, of generating a magnetic flux, and via the additional primary winding of the additional transformer, of generating an additional magnetic flux, opposite of the magnetic flux.

For both the differential amplifier and the additional differential amplifier, the output may be connected to the second input of the respective differential amplifier through the first impedance. For both the differential amplifier and the additional differential amplifier, the second connecting branch includes a second impedance, so that the second input can be connected to the central socket of the respective secondary winding through the second impedance. Preferably, the second impedance is connected to the middle terminal by a ground connection. For both the differential amplifier and the additional differential amplifier, the output may be connected to the second terminal of the respective secondary winding through a third impedance.

In an example, the method comprises a step of providing a differential output amplifier at an output circuit to generate the balanced differential output signal.

In the embodiment of the method, the transformer and the additional transformer, the differential amplifier and the additional differential amplifier may be made according to one or more of the features described in this disclosure.

This disclosure also provides an audio amplifier.

The audio amplifier comprises an amplifier circuit made according to one or more aspects of this disclosure.

The audio amplifier comprises a power amplifier. The amplifier circuit may be located upstream or downstream of the power amplifier (relative to the travel direction of the signal inside the audio amplifier); in other words, the amplifier circuit may be configured to (directly or indirectly) feed an output signal from the amplifier circuit (that is, a balanced differential output signal) to the power amplifier, or to receive an (amplified) output signal from the power amplifier.

When it is located upstream of the power amplifier, the amplifier circuit constitutes or defines a system for the galvanic isolation of the input signal to the audio amplifier. Such a circuit, therefore, may be used to increase the common-mode rejection ratio to shield signal lines, to reduce or eliminate ground loops caused by potential differences between two parts of a circuit or to shield the circuit from external electromagnetic fields. Such an amplifier circuit may also be used to isolate electrically conductive, user-accessible components from the mains so as to ensure electrical safety.

For example, the audio amplifier may be configured to amplify an input signal to a loudspeaker (that is, to feed an amplified signal to a loudspeaker). The audio amplifier, in particular the amplifier circuit of the audio amplifier, may be configured to receive a mains power supply signal through an input connector (which is accessible to a user). In particular, the power amplifier of the audio amplifier may be configured to feed an amplified signal to a loudspeaker. Thus, the amplifier circuit is located upstream of the power amplifier. Used this way, the amplifier circuit is configured to galvanically isolate the input connector from the mains. It is noted that the system made up of the input connector, the audio amplifier and the loudspeaker constitutes an active diffuser.

When it is located downstream of the power amplifier, the amplifier circuit constitutes or defines a system for the galvanic isolation of the output signal from the power amplifier. Such a circuit may be used to perform measurements of current and/or voltage of the output signal from the power amplifier.

For example, the audio amplifier may be configured to perform a measurement of current and/or voltage of the signal output from the power amplifier. The amplifier circuit of the audio amplifier may be configured to receive an output signal from the power amplifier. The amplifier circuit of the audio amplifier may be configured to generate an output signal representing a value of a current and/or voltage output by the power amplifier. The audio amplifier may comprise a shunt resistor located at the output of the power amplifier (that is, the shunt resistor is configured to receive the output signal from the power amplifier). The amplifier circuit may be connected to the ends of the shunt resistor.

Thus, when the amplifier circuit is located this way, its purpose is to reduce the common-mode rejection ratio, hence to perform a more accurate measurement at the ends of the shunt resistor.

According to an aspect of this disclosure, the audio amplifier comprises a first stage, including an amplifier circuit according to one or more aspects of this disclosure, and a second stage, including a power amplifier according to one or more aspects of this disclosure. The first stage may be located upstream or downstream of the second stage; thus, the amplifier circuit is located upstream or downstream of the power amplifier so as to make the amplifier circuit operate in one of the modes described above.

In an example, the second stage is configured to receive the balanced differential output signal from the first stage. Thus, the first stage defines a stage for preconditioning the input signal to the power amplifier. The audio amplifier may comprises a third stage, including an additional amplifier circuit according to one or more aspects of this disclosure. Thus, the third stage, in particular the additional amplifier circuit, may make the amplifier circuit operate in one of the modes described above.

In an example, the third stage is configured to receive an output signal from the power amplifier, that is, from the second stage.

In particular, the third stage, that is, the additional amplifier circuit, is configured to perform a measurement of the output current and/or voltage from the second stage.

Thus, it is noted that there may be at least three different modes of embodying the audio amplifier. In a first mode, the audio amplifier comprises one (single) amplifier circuit, located upstream of the power amplifier; in this mode, there are a first stage, comprising the amplifier circuit, and a second stage, comprising the power amplifier. In a second mode, the audio amplifier comprises one (single) amplifier circuit, located downstream of the power amplifier; in this mode, there are a second stage, comprising the power amplifier, and a first stage (downstream of the second), comprising the amplifier circuit. In a third mode, the audio amplifier comprises an amplifier circuit located upstream of the power amplifier and comprises an additional amplifier downstream of the power amplifier; in this mode, there are a first stage, comprising the amplifier circuit, a second stage, comprising the power amplifier and located downstream of the first stage, and a third stage, comprising the additional amplifier circuit and located downstream of the second stage.

The amplifier circuit may comprise a processing stage. The processing stage may be located between the amplifier circuit and the power amplifier (that is, between the first stage and the second stage). Thus, the processing stage is configured to process an output signal from the first stage and to feed the processed output signal from the first stage to the second stage (in particular, according to the first and second modes). In an example, the processing stage may be located between the amplifier circuit and the power amplifier and/or between the power amplifier and the additional amplifier circuit (that is, between the first stage and the second stage and/or between the second stage and the third stage). The processing stage may comprise at least an analog-to-digital converter and a digital signal processor. The processing stage may comprise at least a digital-to-analog converter.

This and other features will become more apparent from the following description of a preferred embodiment, illustrated by way of non-limiting example in the accompanying drawings, in which:
- Figure 1 illustrates an amplifier circuit according to one or more aspects of this disclosure;
- Figures 2A-2C illustrates an audio amplifier according to one or more aspects of this disclosure;
- Figures 3A and 3B illustrate an audio amplifier according to one or more aspects of this disclosure.

The numeral 1 in the drawings denotes an amplifier circuit. The amplifier circuit 1 comprises an input stage I for receiving as input an audio signal Vᵢₙ, representing the audio signal to be amplified. The input stage I comprises a first input node IN₊ responsible for receiving a first input signal Vᵢₙ₊. The input stage I comprises a second input node IN- responsible for receiving a second input signal Vᵢₙ₋. Therefore, the input stage I is an input stage for balancing the input audio signal Vᵢₙ, where the second input signal Vᵢₙ₋ is 180° out of phase with the first input signal Vᵢₙ₊.

The amplifier circuit 1 comprises an isolating stage TI, connected to the input stage I.

The isolating stage TI comprises a transformer T and an additional transformer T'. The transformer T includes a primary winding L₁, having a first terminal m₁ (that is, a first end) and a second terminal m₂, or second end. The first terminal m₁ of the primary winding L₁ is connected to the first input node IN₊ to receive the first input signal Vᵢₙ₊. The additional transformer T' includes an additional primary winding L₁', having a first terminal m₁ (that is, a first end) and a second terminal m₂, (that is, a second end). The first terminal m₁ of the additional primary winding L₁' is connected to the second input node IN-. The second terminal m₂ of the primary winding L₁ and the second terminal m₂ of the additional primary winding L₁' are electrically connected in series so that the transformer T and the additional transformer T' are electrically connected in series between the first input node IN₊ and IN-. Preferably, the second terminal m₂ of the primary winding L₁ is connected to the first input node IN₊ through a first input resistor Rᵢₙ₊ and the second terminal m₂ of the additional primary winding L₁' is connected to the second input node IN-. In particular, the primary winding L₁ and the additional primary winding L₁' are connected to each other so as to have discordant polarity. In particular, the magnetic flux generated by the primary winding L₁ is the opposite of the magnetic flux generated by the additional primary winding L₁'.

The transformer T comprises a secondary winding L₂, including a first terminal m₁ (that is, a first end) and a second terminal m₂, (that is, a second end). The secondary winding L₂ comprises a first secondary winding L₂₁ including the first terminal m₁ of the secondary winding L₂, and a second secondary winding L₂₂ including the second terminal m₂ of the secondary winding L₂. The first secondary winding L₂₁ and the second secondary winding L₂₂ are connected to each other by a middle terminal m₃ of the secondary winding L₂. The first secondary winding L₂₁ and the second secondary winding L₂₂ are connected to each other so as to have concordant polarity. The primary winding L₁ and the secondary winding L₂ of the transformer T have concordant polarity, that is, additive polarity.

The additional transformer T' comprises a secondary winding L₂', including a first terminal m₁ (that is, a first end) and a second terminal m₂, (that is, a second end). The secondary winding L₂ comprises an additional first secondary winding L₂₁' including the first terminal m₁ of the additional secondary winding L₂', and a second secondary winding L₂₂' including the second terminal m₂ of the additional secondary winding L₂'. The additional first secondary winding L₂₁' and the additional second secondary winding L₂₂' are connected to each other by a middle terminal m₃ of the additional secondary winding L₂'. The additional first secondary winding L₂₁' and the additional second secondary winding L₂₂' are connected to each other so as to have concordant polarity. The additional primary winding L₁' and the additional secondary winding L₂' of the additional transformer T' have concordant polarity, that is, additive polarity.

The transformer T and the additional transformer T' define a transformer pair. In an example, the amplifier circuit 1 may comprise a plurality of transformer pairs.

The primary winding L₁ of the transformer T and the additional primary winding L₁' of the additional transformer T' are connected in such a way as to have discordant polarity.

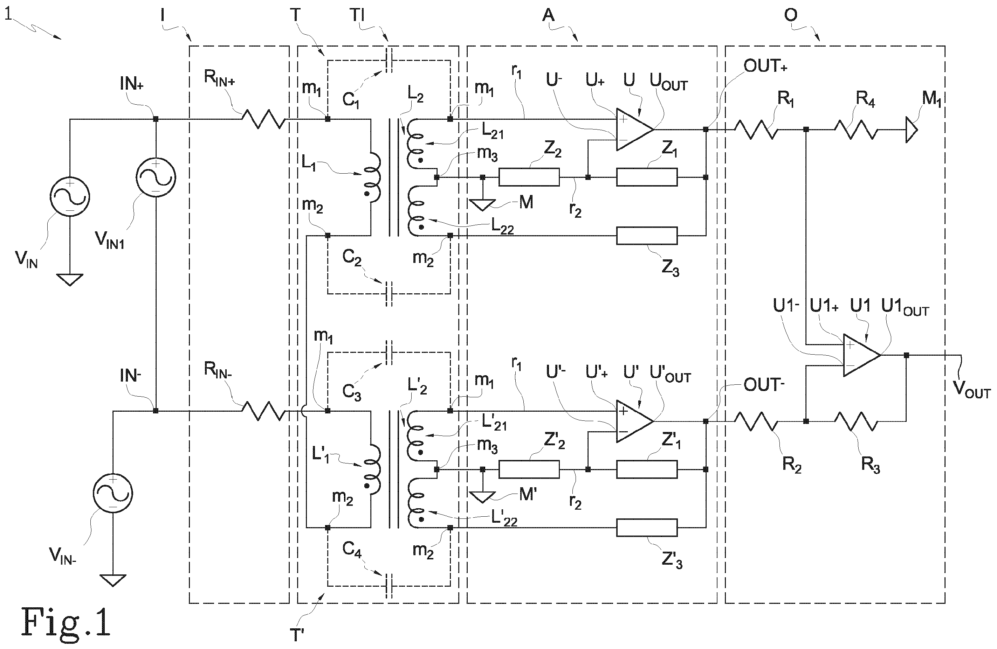

Shown by way of example in Figure 1 is an amplifier circuit 1 where the primary winding L₁ of the transformer T and the additional primary winding L₁' of the additional transformer T' are connected in such a way as to have discordant polarity and the polarity of both of the first primary windings L₂₁ and L₂₁' is concordant with the polarity of the respective second secondary windings L₂₂, L₂₂'. The polarity of both the primary winding L₁ of the transformer T and the additional primary winding L₁' of the additional transformer T' may be inverted with respect to those shown in Figure 1. The polarities of all the windings may also be inverted with respect to those shown in Figure 1.

In particular, it is noted that the secondary winding L₂ and the additional secondary winding L₂' are in separate magnetic circuits.

In the drawings, the stray capacitance produced between the primary winding L₁ and the first secondary winding L₂₁ of the transformer T and between the primary winding L₁ and the second secondary winding L₂₂ of the transformer T are labelled C1 and C2 respectively; the stray capacitance produced between the additional primary winding L₁' and the additional first secondary winding L₂₁' of the additional transformer T' and between the additional primary winding L₁' and the additional second secondary winding L₂₂' of the additional transformer T' are labelled C3 and C4 respectively.

The amplifier circuit 1 comprises an amplifying stage A, connected to the isolating stage TI.

The amplifying stage A comprises a differential amplifier U, including a first input U₊, defining a non-inverting input for the differential amplifier U, a second input U-, defining an inverting input for the differential amplifier U, and an output Uₒᵤₜ for generating a differential signal at a first output node OUT₊. The first input U₊ is connected to the first terminal m₁ of the secondary winding L₂ by a first connecting branch r₁, and the second input U- is connected to the middle terminal m₃ of the secondary winding L₂ by a second connecting branch r₂, and to the output Uₒᵤₜ. The output Uₒᵤₜ is also connected to the second terminal m₂ of the secondary winding L₂.

In particular, the output Uₒᵤₜ is connected to the second input U- through a first impedance Z₁, the second input U₊ is connected to the middle terminal m₃ through a second impedance Z₂ and the second impedance Z₂ is connected to the middle terminal m₃ of the secondary winding L₂ by a ground connection M. The output Uₒᵤₜ is connected to the second terminal m₂ of the secondary winding L₂ through a third impedance Z₃.

The amplifying stage A comprises an additional differential amplifier U', including a first input U₊', defining a non-inverting input for the additional differential amplifier U', a second input U₋', defining an inverting input for the additional differential amplifier U', and an output Uₒᵤₜ' for generating an additional differential signal at a second output node OUT₋. The first input U₊' is connected to the first terminal m₁ of the secondary winding L₂ by a first connecting branch r₁, and the second input U-' is connected to the middle terminal m₃ of the secondary winding L₂ by a second connecting branch r₂, and to the output Uₒᵤₜ'. The output Uₒᵤₜ' is also connected to the second terminal m₂ of the additional secondary winding L₂'.

In particular, the output Uₒᵤₜ of the additional differential amplifier U' is connected to the second input U-' of the additional differential amplifier U' through an additional first impedance Z₁', the second input U₊' of the additional differential amplifier U' is connected to the middle terminal m₃ through an additional second impedance Z₂' and the additional second impedance Z₂' is connected to the middle terminal m₃ of the additional secondary winding L₂' by an additional ground connection M'. The output Uₒᵤₜ' of the additional differential amplifier U' is connected to the second terminal m₂ of the additional secondary winding L₂' through an additional third impedance Z₃'.

The amplifier circuit 1 comprises an output circuit O, connected to the amplifying stage A. The output circuit O comprises the first output node OUT₊ to receive the output signal Uₒᵤₜ from the differential amplifier U. The output circuit O comprises the second output node OUT₋ to receive the output signal Uₒᵤₜ' from the additional differential amplifier U'.

The output circuit O comprises a differential output amplifier U1, including a first input U1₊ defining a non-inverting input for the differential output amplifier U1 and connected to the first output node OUT₊ through a first resistor R1. The differential output amplifier U1 includes a second input U1- defining an inverting input for the differential output amplifier U1 and connected to the second output node OUT- through a second resistor R2. The differential output amplifier U1 includes an output U1ₒᵤ for generating a differential output signal Vₒᵤₜ. The output U1ₒᵤₜ is connected to the second input U- of the differential output amplifier U1 through a third resistor R3. The first output U1₊ is connected to a ground output M1 through a fourth resistor R4.

The numeral 100 in the drawings denotes an audio amplifier.

The audio amplifier 100 comprises an amplifier circuit 1. The audio amplifier 100 comprises a power amplifier 2. In an example, the audio amplifier 100 comprises a first stage S1, including the amplifier circuit 1 and a second stage S2, including the power amplifier 2. The first stage S1 may be located upstream of the second stage S2, so that the amplifier circuit 1 feeds the balanced differential signal Vₒᵤₜ to the audio amplifier 100. Alternatively, the first stage S1 may be located downstream of the second stage S2, so as to receive an amplified signal Vₐ from the power amplifier 2.

In the case where the first stage S1 is located upstream of the second stage S2, the first stage S1 constitutes a stage for preconditioning the signal (prior to the power amplifying stage). In the case where the first stage S1 is located downstream of the second stage S2, the first stage S1 constitutes a stage for measuring the output signal from the power amplifier 2.

The audio amplifier 100 comprises a processing stage S4, located between the first stage S1 and the second stage S2. Thus, the processing stage S4 is configured to receive the differential output signal Vₒᵤₜ from the first stage S1 and to feed the processed differential output signal Vₒᵤₜ to the second stage S2. Preferably, the processing stage S4 includes an analog-to-digital converter ADC1 and a digital signal processor PD; in addition, the processing stage includes a digital-to-analog converter ADC2.

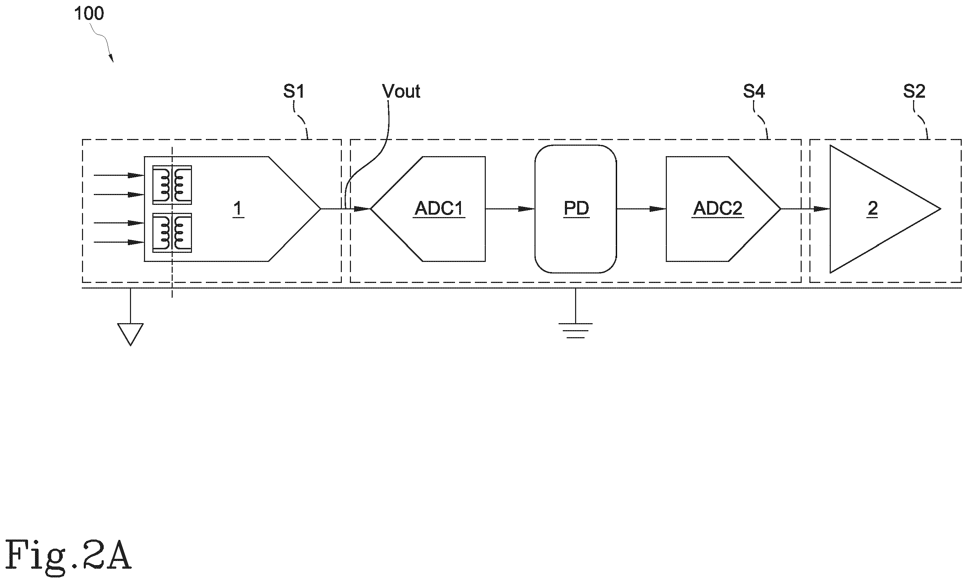

Figure 2A illustrates, by way of an example, an audio amplifier 100 where the first stage S1 is located upstream of the second stage S2.

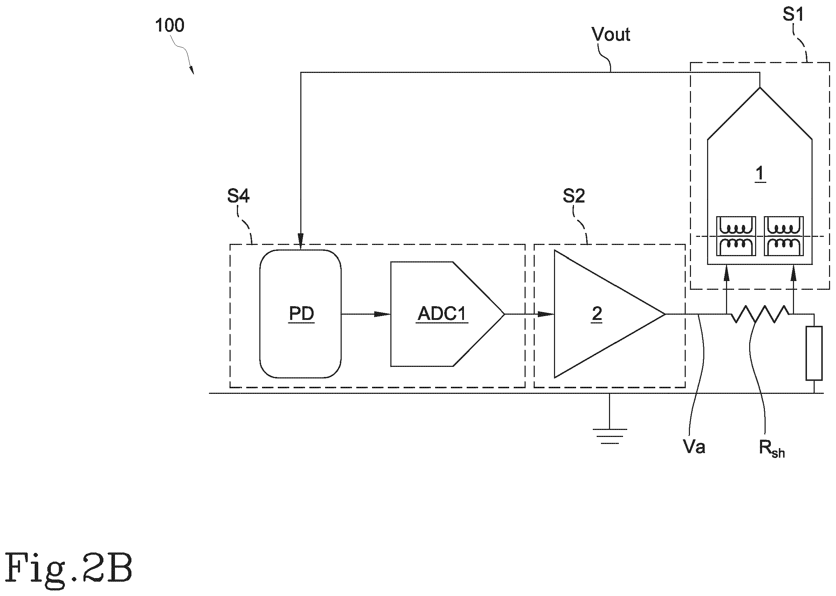

Figure 2B illustrates, by way of an example, an audio amplifier 100 where the first stage S1 is located downstream of the second stage S2. The audio amplifier 100 may include a shunt resistor Rₛₕ, which is part of the measuring stage; the amplifier circuit 1 is connected to the ends of the shunt resistor Rₛₕ to perform a measurement of the current and/or voltage at the ends of the shunt resistor Rₛₕ.

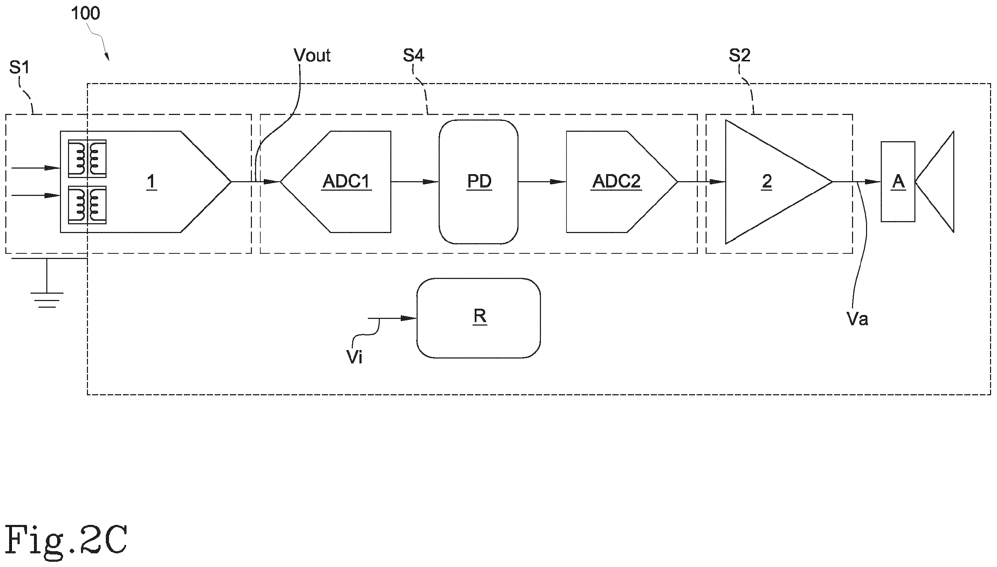

Figure 2C illustrates, by way of an example, an audio amplifier 100 where the first stage S1 is located upstream of the second stage S2; the audio amplifier 100 is configured to feed an amplified output signal Vₐ from the power amplifier 2 to a loudspeaker A. In the detail, Figure 3C illustrates an active audio diffuser comprising an audio amplifier 100 configured to receive an input power supply signal Vᵢ from the mains R through an input connector; the amplifier circuit 1 is configured to receive the input power supply signal Vᵢ and to provide a balanced differential output signal Vₒᵤₜ which it feeds to the processing stage S4. The power amplifier 2 is configured to receive the balanced differential output signal Vₒᵤₜ from the processing stage S4 and to provide an amplified output signal Vₐ, which it feeds to the loudspeaker A. Thus, in this case, the amplifier circuit 1, in the first stage S1, constitutes a stage for isolating the input connector from the external mains.

In an example, the audio amplifier 100 comprises an amplifier circuit 1 located in the first stage S1, a power amplifier 2 located in the second stage S2, downstream of the first stage S1, and an additional amplifier circuit located in a third stage, downstream of the second stage S2 and configured to perform a measurement of output current and/or voltage from the power amplifier 2.

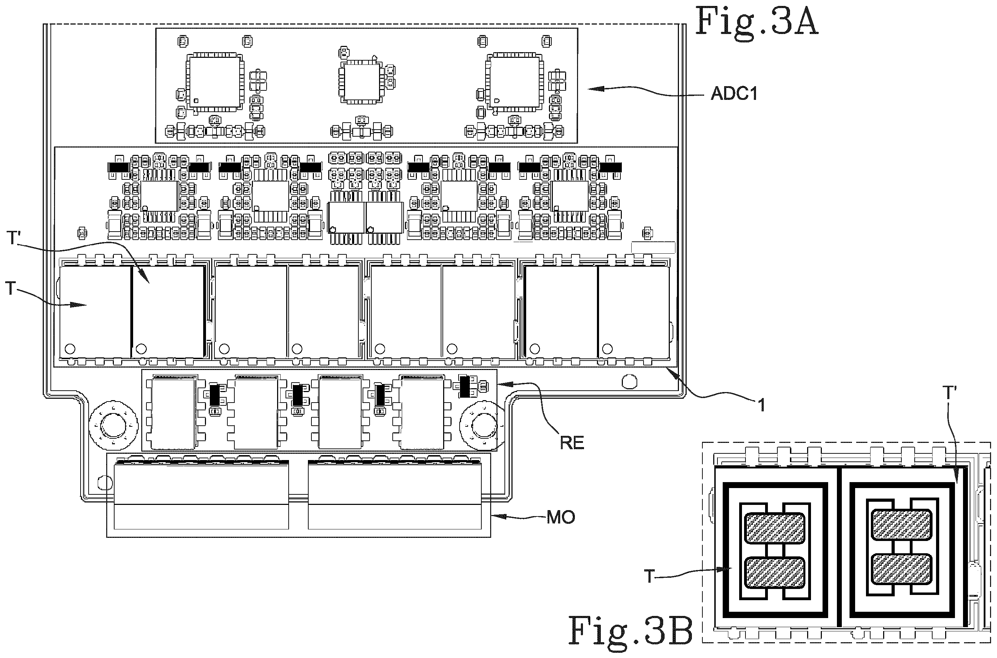

Figure 3A shows, by way of an example, an electronic card on which there is an amplifier circuit 1, an analog-to-digital converter ADC1, a plurality of relays RE and pins MO. The transformer T and the additional transformer T' are mounted side by side and oriented in the same way. In particular, the turns of the windings of the transformer T and of the additional transformer T' are wound along axes which are parallel to each other. Additionally, the transformer T and the additional transformer T' are located relative to each other at a distance such that an external magnetic flux generates the same current in the transformer T and in the additional transformer T'. Thus, each transformer T and T' of the transformer pair has the same mutual orientation (as illustrated, for example, in Figure 3B).

## Claims

1. An amplifier circuit (1) for amplifying an audio signal, comprising:
- an input stage (I) having a first pin (IN₊) for receiving a first input signal (Vᵢₙ₊) representing the audio signal, and a second pin (IN-) for receiving a second input signal (Vᵢₙ₋) representing the audio signal and 180° out of phase with respect to the first input signal (Vᵢₙ₊);
- a transformer (T) including a primary winding (L₁) and a secondary winding (L₂), the secondary winding (L₂) defining a first terminal (m₁), a second terminal (m₂) and a middle terminal (m₃);
- a differential amplifier (U), having
a first input (U₊), defining a non-inverting input of the differential amplifier (U) and electrically connected to the first terminal (m₁) of the secondary winding (L₂) by a first connecting branch (r₁);
a second input (U₋), defining an inverting input of the differential amplifier (U) and electrically connected to the middle terminal (m₃) of the secondary winding (L₂) by a second connecting branch (r₂); and
an output (Uₒᵤₜ) connected to the second terminal (m₂) of the secondary winding (L₂),
- an additional transformer (T') including an additional primary winding (L₁') and an additional secondary winding (L₂'), the additional secondary winding (L₂') defining a first terminal (m₁), a second terminal (m₂) and a middle terminal (m₃), wherein the primary winding (L₁) and the additional primary winding (L₁') are electrically connected in series between the first pin (IN₊) and the second pin (IN-) and are connected to each other so as to have discordant polarity;
- an additional differential amplifier (U'), having
a first input (U₊'), defining a non-inverting input of the additional differential amplifier (U') and electrically connected to the first terminal (m₁) of the additional secondary winding (L₂') by a first connecting branch (r₁);
a second input (U₋'), defining an inverting input of the additional differential amplifier (U') and electrically connected to the middle terminal (m₃) of the additional secondary winding (L₂') by a second connecting branch (r₂); and
an output (Uₒᵤₜ') connected to the second terminal (m₂) of the additional secondary winding (L₂');
- an output circuit (O) for receiving as input the output signals from the differential amplifier (U) and from the additional differential amplifier (U') to generate a differential output signal (Vₒᵤₜ).

2. The amplifier circuit (1) according to claim 1, wherein the primary winding (L₁) of the transformer (T) and the additional primary winding (L₁') of the additional transformer (T') are respectively configured to generate a magnetic flux and an opposite, additional magnetic flux.

3. The amplifier circuit (1) according to claim 1 or 2, wherein the transformer (T) and the additional transformer (T') are identical, placed side by side and oriented in the same way, so that an external magnetic flux generates the same current in the transformer (T) and in the additional transformer (T').

4. The amplifier circuit (1) according to any one of the preceding claims, wherein, for each of said differential amplifier (U) and additional differential amplifier (U'), the output (Uₒᵤₜ, Uₒᵤₜ') is connected to the second input (U₋, U₋') by a first impedance (Z₁, Z₁').

5. The amplifier circuit (1) according to claim 4, wherein, for each of said differential amplifier (U) and additional differential amplifier (U'):
- the second connecting branch (r₂) includes a second impedance (Z₂, Z₂'), so that the second input (U₋, U₋') is connected to the middle terminal (m₃) of the respective secondary winding (L₂, L₂') by the second impedance (Z₂, Z₂');
- the output (Uₒᵤₜ, Uₒᵤₜ') is connected to the second terminal (m₂) of the respective secondary winding (L₂, L₂') by a third impedance (Z₃, Z₃'), wherein a node of the respective second connecting branch (r2) between the second impedance (Z₂, Z₂') and the middle terminal (m₃) is connected to ground by a ground connection (M, M'), and said first impedance (Z₁, Z₁'), second impedance (Z₂, Z₂') and third impedance (Z₃, Z₃') each comprise a resistive component and a capacitive component.

6. The amplifier circuit (1) according to any one of the preceding claims, wherein the transformer (T) and the additional transformer (T') are identical.

7. The amplifier circuit (1) according to any one of the preceding claims, wherein the transformer (T) comprises a core and the additional transformer (T') comprises an additional core which is distinct from the core of the transformer (T).

8. The amplifier circuit (1) according to any one of the preceding claims, wherein the output circuit (O) comprises a differential output amplifier (U1) to generate the differential output signal (Vₒᵤₜ).

9. An audio amplifier (100), comprising:
- an amplifier circuit (1) according to any one of the preceding claims;
- a power amplifier (2).

10. The audio amplifier (100) according to claim 9, comprising a first stage (S1) including the amplifier circuit (1) and a second stage (S2) including the power amplifier (2), wherein the second stage (S2) is configured to receive the balanced differential output signal (Vₒᵤₜ) from the first stage (S1).

11. The audio amplifier according to claim 10, comprising a third stage including a further amplifier circuit according to any one of claims 1 to 8, the third stage being configured to receive an amplified output signal (Vₐ) from the second stage (S2).

12. A method for amplifying an audio signal, comprising the following steps:
- receiving a first input signal (Vᵢₙ₊), representing the audio signal, at a first pin (IN₊) of an input stage (I);
- at a second pin (IN₋) of the input stage (I), receiving a second input signal (Vᵢₙ₋), representing the audio signal and 180° out of phase with respect to the first input signal (Vᵢₙ₊);
- providing a transformer (T) including a primary winding (L₁) and a secondary winding (L₂), the secondary winding (L₂) defining a first terminal (m₁), a second terminal (m₂) and a middle terminal (m₃);
- providing a differential amplifier (U), having
a first input (U₊), defining a non-inverting input of the differential amplifier (U) and electrically connected to the first terminal (m₁) of the secondary winding (L₂) by a first connecting branch (r₁);
a second input (U₋), defining an inverting input of the differential amplifier (U) and electrically connected to the middle terminal (m₃) of the secondary winding (L₂) by a second connecting branch (r₂); and
an output (Uₒᵤₜ) connected to the second terminal (m₂) of the secondary winding (L₂),
- providing an additional transformer (T') including an additional primary winding (L₁') and an additional secondary winding (L₂') defining a first terminal (m₁), a second terminal (m₂) and a middle terminal (m₃), wherein the primary winding (L₁) and the additional primary winding (L₁') are electrically connected in series between the first pin (IN₊) and the second pin (IN-) and are connected to each other so as to have discordant polarity;
- providing an additional differential amplifier (U'), having
a first input (U₊'), defining a non-inverting input of the additional differential amplifier (U') and electrically connected to the first terminal (m₁) of the additional secondary winding (L₂') by a first connecting branch (r₁);
a second input (U₋'), defining an inverting input of the additional differential amplifier (U') and electrically connected to the middle terminal (m₃) of the additional secondary winding (L₂') by a second connecting branch (r₂); and
an output (Uₒᵤₜ') connected to the second terminal (m₂) of the additional secondary winding (L₂') of the additional transformer (T');
- generating a differential output signal (Vₒᵤₜ) from the output signals from the differential amplifier (U) and from the additional differential amplifier (U') to make the differential output signal (Vₒᵤₜ) available to an output stage.

13. The method according to claim 12, comprising the following steps:
- via the primary winding (L₁) of the transformer (T), generating a magnetic flux;
- via the additional primary winding (L₁') of the additional transformer (T'), generating a magnetic flux, opposite of the magnetic flux generated by the primary winding (L₁),
wherein the transformer (T) and the additional transformer (T') are identical, placed side by side and oriented in the same way, so that an external magnetic flux generates the same current in the transformer (T) and in the additional transformer (T').

14. The method according to claim 12 or 13, wherein, for each of said differential amplifier (U) and additional differential amplifier (U'):
- the output (Uₒᵤₜ, Uₒᵤₜ') is connected to the second input (U₋, U₋') of the respective differential amplifier (U, U') by a first impedance (Z₁, Z₁');
- the second connecting branch (r₂) includes a second impedance (Z₂, Z₂'), so that the second input (U₋, U₋') is connected to the middle terminal (m₃) of the respective secondary winding (L₂, L₂') by the second impedance (Z₂, Z2'), wherein a node of the respective second connecting branch (r2) between the second impedance (Z₂, Z₂') and the middle terminal (m3) is connected to ground by a ground connection (M, M');
- the output (Uₒᵤₜ, Uₒᵤₜ') is connected to the second end of the respective secondary winding (L₂, L₂') by a third impedance (Z₃, Z₃').

15. The method according to any one of claims 12 to 14, comprising a step of providing a differential output amplifier (U1) having an output circuit (O) to generate the differential output signal (Vₒᵤₜ).

## Patentansprüche

1. Verstärkerschaltung (1) zur Verstärkung eines Audiosignals, umfassend:
- eine Eingangsstufe (I), aufweisend einen ersten Kontakt (IN₊) zum Empfangen eines ersten Eingangssignals (Vᵢₙ₊), das das Audiosignal darstellt, und einem zweiten Kontakt (IN₋) zum Empfangen eines zweiten Eingangssignals (Vᵢₙ₋), das das Audiosignal darstellt und in Bezug auf das erste Eingangssignal (Vᵢₙ₊) um 180° phasenverschoben ist;
- einen Transformator (T), beinhaltend eine Primärwicklung (L₁) und eine Sekundärwicklung (L₂), wobei die Primärwicklung (L₂) einen ersten Anschluss (m₁), einen zweiten Anschluss (m₂) und einen mittleren Anschluss (m₃) definiert;
- einen Differenzverstärker (U), aufweisend
einen ersten Eingang (U₊), der einen nichtinvertierenden Eingang des Differenzverstärkers (U) definiert und elektrisch mit dem ersten Anschluss (m₁) der Sekundärwicklung (L₂) durch einen ersten Verbindungszweig (r₁) verbunden ist;
einen zweiten Eingang (U₋), der einen invertierenden Eingang des Differenzverstärkers (U) definiert und elektrisch mit dem mittleren Anschluss (m₃) der Sekundärwicklung (L₂) durch einen zweiten Verbindungszweig (r₂) verbunden ist; und
einen Ausgang (Uₒᵤₜ), der mit dem zweiten Anschluss (m₂) der Sekundärwicklung (L₂) verbunden ist;
- einen zusätzlichen Transformator (T'), beinhaltend eine zusätzliche Primärwicklung (L₁') und eine zusätzliche Sekundärwicklung (L₂'), wobei die zusätzliche Sekundärwicklung (L₂') einen ersten Anschluss (m₁), einen zweiten Anschluss (m₂) und einen mittleren Anschluss (m₃) definiert, wobei die Primärwicklung (L₁) und die zusätzliche Primärwicklung (L₁') elektrisch in Reihe geschaltet zwischen dem ersten Kontakt (IN₊) und dem zweiten Kontakt (IN₋) verbunden sind und miteinander verbunden sind, sodass sie eine entgegengesetzte Polarität aufweisen;
- einen zusätzlichen Differenzverstärker (U'), aufweisend
einen ersten Eingang (U₊'), der einen nichtinvertierenden Eingang des zusätzlichen Differenzverstärkers (U') definiert und elektrisch mit dem ersten Anschluss (m₁) der zusätzlichen Sekundärwicklung (L₂') durch einen ersten Verbindungszweig (r₁) verbunden ist;
einen zweiten Eingang (U₋'), der einen invertierenden Eingang des zusätzlichen Differenzverstärkers (U') definiert und elektrisch mit dem mittleren Anschluss (m₃) der zusätzlichen Sekundärwicklung (L₂') durch einen zweiten Verbindungszweig (r₂) verbunden ist; und
einen Ausgang (Uₒᵤₜ'), der mit dem zweiten Anschluss (m₂) der zusätzlichen Sekundärwicklung (L₂') verbunden ist;
- eine Ausgangsschaltung (O) zum Empfangen der Ausgangssignale von dem Differenzverstärker (U) und von dem zusätzlichen Differenzverstärker (U') als Eingang, um ein Differenzausgangssignal (Vₒᵤₜ) zu generieren.

2. Verstärkerschaltung (1) nach Anspruch 1, wobei die Primärwicklung (L₁) des Transformators (T) und die zusätzliche Primärwicklung (L₁') des zusätzlichen Transformators (T') jeweils ausgelegt sind, um einen Magnetfluss und einen entgegengesetzten zusätzlichen Magnetfluss zu generieren.

3. Verstärkerschaltung (1) nach Anspruch 1 oder 2, wobei der Transformator (T) und der zusätzliche Transformator (T') identisch sind, nebeneinander platziert und auf dieselbe Weise ausgerichtet sind, sodass ein externer Magnetfluss denselben Strom in dem Transformator (T) und in dem zusätzlichen Transformator (T') generiert.

4. Verstärkerschaltung (1) nach einem der vorhergehenden Ansprüche, wobei der Ausgang (Uₒᵤₜ, Uₒᵤₜ') sowohl für den Differenzverstärker (U) als auch den zusätzlichen Differenzverstärker (U') mit dem zweiten Eingang (U₋, U₋ ') durch eine erste Impedanz (Z₁, Z₁') verbunden ist.

5. Verstärkerschaltung (1) nach Anspruch 4, wobei sowohl für den Differenzverstärker (U) als auch den zusätzlichen Differenzverstärker (U') Folgendes gilt:
- der zweite Verbindungszweig (r₂) beinhaltet eine zweite Impedanz (Z₂, Z₂'), sodass der zweite Eingang (U₋, U₋') mit dem mittleren Anschluss (m₃) der jeweiligen Sekundärwicklung (L₂, L₂') durch die zweite Impedanz (Z₂, Z₂') verbunden ist;
- der Ausgang (Uₒᵤₜ, Uₒᵤₜ') ist mit dem zweiten Anschluss (m₂) der jeweiligen Sekundärwicklung (L₂, L₂') durch eine dritte Impedanz (Z₃, Z₃') verbunden, wobei ein Knoten des jeweiligen zweiten Verbindungszweigs (r2) zwischen der zweiten Impedanz (Z₂, Z₂') und dem mittleren Anschluss (m₃) durch eine Masseverbindung (M, M') mit Masse verbunden ist und die erste Impedanz (Z₁, Z₁'), die zweite Impedanz (Z₂, Z₂') und die dritte Impedanz (Z₃, Z₃') jeweils eine resistive und eine kapazitive Komponente umfassen.

6. Verstärkerschaltung (1) nach einem der vorhergehenden Ansprüche, wobei der Transformator (T) und der zusätzliche Transformator (T') identisch sind.

7. Verstärkerschaltung (1) nach einem der vorhergehenden Ansprüche, wobei der Transformator (T) einen Kern umfasst und der zusätzliche Transformator (T') einen zusätzlichen Kern umfasst, der sich von dem Kern des Transformators (T) unterscheidet.

8. Verstärkerschaltung (1) nach einem der vorhergehenden Ansprüche, wobei die Ausgangsschaltung (O) einen Differenzausgangsverstärker (U1) zum Generieren des Differenzausgangssignals (Vₒᵤₜ) umfasst.

9. Audioverstärker (100), umfassend:
- eine Verstärkerschaltung (1) nach einem der vorhergehenden Ansprüche;
- einen Leistungsverstärker (2).

10. Audioverstärker (100) nach Anspruch 9, umfassend eine erste Stufe (S1), die die Verstärkerschaltung (1) beinhaltet, und eine zweite Stufe (S2), die den Leistungsverstärker (2) beinhaltet, wobei die zweite Stufe (S2) ausgelegt ist, um das symmetrische Differenzausgangssignal (Vₒᵤₜ) von der ersten Stufe (S1) zu empfangen.

11. Audioverstärker nach Anspruch 10, umfassend eine dritte Stufe, die eine weitere Verstärkerschaltung nach einem der Ansprüche 1 bis 8 beinhaltet,
wobei die dritte Stufe ausgelegt ist, um ein verstärktes Ausgangssignal (Vₐ) von der zweiten Stufe (S2) zu empfangen.

12. Verfahren zur Verstärkung eines Audiosignals, das die folgenden Schritte umfasst:
- Empfangen eines ersten Eingangssignals (Vᵢₙ₊), das das Audiosignal darstellt, an einem ersten Kontakt (IN₊) einer Eingangsstufe (I);
- an einem zweiten Kontakt (IN₋) der Eingangsstufe (I) Empfangen eines zweiten Eingangssignals (Vᵢₙ₋), das das Audiosignal darstellt und in Bezug auf das erste Eingangssignal (Vᵢₙ₊) um 180° phasenverschoben ist;
- Bereitstellen eines Transformators (T), beinhaltend eine Primärwicklung (L₁) und eine Sekundärwicklung (L₂), wobei die Primärwicklung (L₂) einen ersten Anschluss (m₁), einen zweiten Anschluss (m₂) und einen mittleren Anschluss (m₃) definiert;
- Bereitstellen eines Differenzverstärkers (U), aufweisend
einen ersten Eingang (U₊), der einen nichtinvertierenden Eingang des Differenzverstärkers (U) definiert und elektrisch mit dem ersten Anschluss (m₁) der Sekundärwicklung (L₂) durch einen ersten Verbindungszweig (r₁) verbunden ist;
einen zweiten Eingang (U₋), der einen invertierenden Eingang des Differenzverstärkers (U) definiert und elektrisch mit dem mittleren Anschluss (m₃) der Sekundärwicklung (L₂) durch einen zweiten Verbindungszweig (r₂) verbunden ist; und
einen Ausgang (Uₒᵤₜ), der mit dem zweiten Anschluss (m₂) der Sekundärwicklung (L₂) verbunden ist;
- Bereitstellen eines zusätzliches Transformator (T'), beinhaltend eine zusätzliche Primärwicklung (L₁') und eine zusätzliche Sekundärwicklung (L₂'), die einen ersten Anschluss (m₁), einen zweiten Anschluss (m₂) und einen mittleren Anschluss (m3) definiert, wobei die Primärwicklung (L₁) und die zusätzliche Primärwicklung (L₁') elektrisch in Reihe geschaltet zwischen dem ersten Kontakt (IN₊) und dem zweiten Kontakt (IN₋) verbunden sind und miteinander verbunden sind, sodass sie eine entgegengesetzte Polarität aufweisen;
- Bereitstellen eines zusätzlichen Differenzverstärkers (U'), aufweisend einen ersten Eingang (U₊'), der einen nichtinvertierenden Eingang des zusätzlichen Differenzverstärkers (U') definiert und elektrisch mit dem ersten Anschluss (m₁) der zusätzlichen Sekundärwicklung (L₂') durch einen ersten Verbindungszweig (r₁) verbunden ist;
einen zweiten Eingang (U₋'), der einen invertierenden Eingang des zusätzlichen Differenzverstärkers (U') definiert und elektrisch mit dem mittleren Anschluss (m₃) der zusätzlichen Sekundärwicklung (L₂') durch einen zweiten Verbindungszweig (r₂) verbunden ist; und
einen Ausgang (Uₒᵤₜ,), der mit dem zweiten Anschluss (m₂) der zusätzlichen Sekundärwicklung (L₂') des zusätzlichen Transformators (T') verbunden ist;
- Generieren eines Differenzausgangssignals (Vₒᵤₜ) von den Ausgangsignalen von dem Differenzverstärker (U) und von dem zusätzlichen Differenzverstärker (U'), um dafür zu sorgen, dass das Differenzausgangssignal (Vₒᵤₜ) für eine Ausgangsstufe verfügbar ist.

13. Verfahren nach Anspruch 12, umfassend die folgenden Schritte:
- über die Primärwicklung (L₁) des Transformators (T) Generieren eines Magnetflusses;
- über die zusätzliche Primärwicklung (L₁') des zusätzlichen Transformators (T') Generieren eines Magnetflusses, der dem durch die Primärwicklung (L₁) generierten Magnetfluss entgegengesetzt ist,
wobei der Transformator (T) und der zusätzliche Transformator (T') identisch sind, nebeneinander platziert und auf dieselbe Weise ausgerichtet sind, sodass ein externer Magnetfluss denselben Strom in dem Transformator (T) und in dem zusätzlichen Transformator (T') generiert.

14. Verfahren nach Anspruch 12 oder 13, wobei sowohl für den Differenzverstärker (U) als auch den zusätzlichen Differenzverstärker (U') Folgendes gilt:
- der Ausgang (Uₒᵤₜ, Uₒᵤₜ') ist mit dem zweiten Eingang (U₋, U₋') des jeweiligen Differenzverstärkers (U, U') durch eine erste Impedanz (Z₁, Z₁') verbunden;
- der zweite Verbindungszweig (r₂) beinhaltet eine zweite Impedanz (Z₂, Z₂'), sodass der zweite Eingang (U₋, U₋') mit dem mittleren Anschluss (m₃) der jeweiligen Sekundärwicklung (L₂, L₂') durch die zweite Impedanz (Z₂, Z₂') verbunden ist, wobei ein Knoten des jeweiligen zweiten Verbindungszweigs (r2) zwischen der zweiten Impedanz (Z₂, Z₂') und dem mittleren Anschluss (m3) durch eine Masseverbindung (M, M') mit Masse verbunden ist;
- der Ausgang (Uₒᵤₜ, Uₒᵤₜ') ist mit dem zweiten Ende der jeweiligen Sekundärwicklung (L₂, L₂') durch eine dritte Impedanz (Z₃, Z³') verbunden.

15. Verfahren nach einem der Ansprüche 12 bis 14, umfassend einen Schritt des Bereitstellens eines Differenzverstärkers (U1), aufweisend eine Ausgangsschaltung (O) zum Generieren des Differenzausgangssignals (Vₒᵤₜ).

## Revendications

1. Circuit amplificateur (1) d'amplification d'un signal audio, comprenant :
- un étage d'entrée (I) comportant une première broche (IN₊) pour recevoir un premier signal d'entrée (Vᵢₙ₊) représentant le signal audio, et une seconde broche (IN₋ ) pour recevoir un second signal d'entrée (Vᵢₙ₋) représentant le signal audio et déphasé de 180° par rapport au premier signal d'entrée (Vᵢₙ₊) ;
- un transformateur (T) incluant un enroulement primaire (L₁) et un enroulement secondaire (L₂), l'enroulement secondaire (L₂) définissant une première borne (m₁), une seconde borne (m₂) et une borne médiane (m₃) ;
- un amplificateur différentiel (U), comportant
une première entrée (U₊), définissant une entrée non inverseuse de l'amplificateur différentiel (U) et connectée électriquement à la première borne (m₁) de l'enroulement secondaire (L₂) par une première branche de connexion (r₁) ;
une seconde entrée (U₋), définissant une entrée inverseuse de l'amplificateur différentiel (U) et connectée électriquement à la borne médiane (m₃) de l'enroulement secondaire (L₂) par une seconde branche de connexion (r₂) ; et
une sortie (Uₒᵤₜ) connectée à la seconde borne (m₂) de l'enroulement secondaire (L₂),
- un transformateur supplémentaire (T') incluant un enroulement primaire supplémentaire (L₁') et un enroulement secondaire supplémentaire (L₂'), l'enroulement secondaire supplémentaire (L₂') définissant une première borne (m₁), une seconde borne (m₂) et une borne médiane (m₃), dans lequel l'enroulement primaire (L₁) et l'enroulement primaire supplémentaire (L₁') sont connectés électriquement en série entre la première broche (IN₊) et la seconde broche (IN₋) et sont connectés les uns aux autres de manière à avoir une polarité discordante ;
- un amplificateur différentiel supplémentaire (U'), comportant
une première entrée (U₊'), définissant une entrée non inverseuse de l'amplificateur différentiel supplémentaire (U') et connectée électriquement à la première borne (m₁) de l'enroulement secondaire supplémentaire (L₂') par une première branche de connexion (r₁) ;
une seconde entrée (U₋'), définissant une entrée inverseuse de l'amplificateur différentiel supplémentaire (U') et connectée électriquement à la borne médiane (m₃) de l'enroulement secondaire supplémentaire (L₂') par une seconde branche de connexion (r₂) ; et
une sortie (Uₒᵤₜ') connectée à la seconde borne (m₂) de l'enroulement secondaire supplémentaire (L₂') ;
- un circuit de sortie (O) pour recevoir en entrée les signaux de sortie de l'amplificateur différentiel (U) et de l'amplificateur différentiel supplémentaire (U') pour générer un signal de sortie différentiel (Vₒᵤₜ).

2. Circuit amplificateur (1) selon la revendication 1, dans lequel l'enroulement primaire (L₁) du transformateur (T) et l'enroulement primaire supplémentaire (L₁') du transformateur supplémentaire (T') sont respectivement configurés pour générer un flux magnétique et un flux magnétique supplémentaire opposé.

3. Circuit amplificateur (1) selon la revendication 1 ou 2, dans lequel le transformateur (T) et le transformateur supplémentaire (T') sont identiques, placés côte à côte et orientés de la même manière, de sorte qu'un flux magnétique externe génère le même courant dans le transformateur (T) et dans le transformateur supplémentaire (T').

4. Circuit amplificateur (1) selon l'une quelconque des revendications précédentes, dans lequel, pour chacun desdits amplificateur différentiel (U) et amplificateur différentiel supplémentaire (U'), la sortie (Uₒᵤₜ, Uₒᵤₜ') est connectée à la seconde entrée (U₋, U₋') par une première impédance (Z₁, Z₁').

5. Circuit amplificateur (1) selon la revendication 4, dans lequel, pour chacun desdits amplificateur différentiel (U) et amplificateur différentiel supplémentaire (U') :
- la seconde branche de connexion (r₂) inclut une deuxième impédance (Z₂, Z₂'), de sorte que la seconde entrée (U₋, U₋') est connectée à la borne médiane (m₃) de l'enroulement secondaire respectif (L₂, L₂') par la deuxième impédance (Z₂, Z₂') ;
- la sortie (Uₒᵤₜ, Uₒᵤₜ') est connectée à la seconde borne (m₂) de l'enroulement secondaire respectif (L₂, L₂') par une troisième impédance (Z₃, Z₃'), dans lequel un nœud de la seconde branche de connexion respective (r2) entre la deuxième impédance (Z₂, Z₂') et la borne médiane (m₃) est connecté à la masse par une connexion à la masse (M, M'), et ladite première impédance (Z₁, Z₁'), ladite deuxième impédance (Z₂, Z₂') et ladite troisième impédance (Z₃, Z₃') comprennent chacune un composant résistif et un composant capacitif.

6. Circuit amplificateur (1) selon l'une quelconque des revendications précédentes, dans lequel le transformateur (T) et le transformateur supplémentaire (T') sont identiques.

7. Circuit amplificateur (1) selon l'une quelconque des revendications précédentes, dans lequel le transformateur (T) comprend un noyau et le transformateur supplémentaire (T') comprend un noyau supplémentaire qui est distinct du noyau du transformateur (T).

8. Circuit amplificateur (1) selon l'une quelconque des revendications précédentes, dans lequel le circuit de sortie (O) comprend un amplificateur de sortie différentiel (U1) pour générer le signal de sortie différentiel (Vₒᵤₜ).

9. Amplificateur audio (100), comprenant :
- un circuit amplificateur (1) selon l'une quelconque des revendications précédentes ;
- un amplificateur de puissance (2).

10. Amplificateur audio (100) selon la revendication 9, comprenant un premier étage (S1) incluant le circuit amplificateur (1) et un deuxième étage (S2) incluant l'amplificateur de puissance (2), dans lequel le deuxième étage (S2) est configuré pour recevoir le signal de sortie différentiel équilibré (Vₒᵤₜ) en provenance du premier étage (S1).

11. Amplificateur audio selon la revendication 10, comprenant un troisième étage incluant un ultérieur circuit amplificateur selon l'une quelconque des revendications 1 à 8,
le troisième étage étant configuré pour recevoir un signal de sortie amplifié (Vₐ) en provenance du deuxième étage (S2).

12. Procédé d'amplification d'un signal audio, comprenant les étapes suivantes :
- recevoir un premier signal d'entrée (Vᵢₙ₊), représentant le signal audio, sur une première broche (IN₊) d'un étage d'entrée (I) ;
- sur une seconde broche (IN₋) de l'étage d'entrée (I), recevoir un second signal d'entrée (Vᵢₙ₋), représentant le signal audio et déphasé de 180° par rapport au premier signal d'entrée (Vᵢₙ₊) ;
- prévoir un transformateur (T) incluant un enroulement primaire (L₁) et un enroulement secondaire (L₂), l'enroulement secondaire (L₂) définissant une première borne (m₁), une seconde borne (m₂) et une borne médiane (m₃) ;
- prévoir un amplificateur différentiel (U), comportant une première entrée (U₊), définissant une entrée non inverseuse de l'amplificateur différentiel (U) et connectée électriquement à la première borne (m₁) de l'enroulement secondaire (L₂) par une première branche de connexion (r₁) ;
une seconde entrée (U₋), définissant une entrée inverseuse de l'amplificateur différentiel (U) et connectée électriquement à la borne médiane (m₃) de l'enroulement secondaire (L₂) par une seconde branche de connexion (r₂) ; et
une sortie (Uₒᵤₜ) connectée à la seconde borne (m₂) de l'enroulement secondaire (L₂),
- prévoir un transformateur supplémentaire (T') incluant un enroulement primaire supplémentaire (L₁') et un enroulement secondaire supplémentaire (L₂') définissant une première borne (m₁), une seconde borne (m₂) et une borne médiane (m3), dans lequel l'enroulement primaire (L₁) et l'enroulement primaire supplémentaire (L₁') sont connectés électriquement en série entre la première broche (IN₊) et la seconde broche (IN₋) et sont connectés les uns aux autres de manière à avoir une polarité discordante ;
- prévoir un amplificateur différentiel supplémentaire (U'), comportant une première entrée (U₊'), définissant une entrée non inverseuse de l'amplificateur différentiel supplémentaire (U') et connectée électriquement à la première borne (m₁) de l'enroulement secondaire supplémentaire (L₂') par une première branche de connexion (r₁) ;
une seconde entrée (U₋'), définissant une entrée inverseuse de l'amplificateur différentiel supplémentaire (U') et connectée électriquement à la borne médiane (m₃) de l'enroulement secondaire supplémentaire (L₂') par une seconde branche de connexion (r₂) ; et
une sortie (Uₒᵤₜ') connectée à la seconde borne (m₂) de l'enroulement secondaire supplémentaire (L₂') du transformateur supplémentaire (T') ;
- générer un signal de sortie différentiel (Vₒᵤₜ) provenant des signaux de sortie de l'amplificateur différentiel (U) et de l'amplificateur différentiel supplémentaire (U') pour rendre le signal de sortie différentiel (Vₒᵤₜ) disponible à un étage de sortie.

13. Procédé selon la revendication 12, comprenant les étapes suivantes :
- via l'enroulement primaire (L₁) du transformateur (T), générer un flux magnétique ;
- via l'enroulement primaire supplémentaire (L₁') du transformateur supplémentaire (T'),
générer un flux magnétique, opposé au flux magnétique généré par l'enroulement primaire (L₁),
dans lequel le transformateur (T) et le transformateur supplémentaire (T') sont identiques, placés côte à côte et orientés de la même manière, de sorte qu'un flux magnétique externe génère le même courant dans le transformateur (T) et dans le transformateur supplémentaire (T').

14. Procédé selon la revendication 12 ou 13, dans lequel, pour chacun desdits amplificateur différentiel (U) et amplificateur différentiel supplémentaire (U') :
- la sortie (Uₒᵤₜ, Uₒᵤₜ') est connectée à la seconde entrée (U₋, U₋') de l'amplificateur différentiel respectif (U, U') par une première impédance (Z₁, Z₁') ;
- la seconde branche de connexion (r₂) inclut une deuxième impédance (Z₂, Z₂'), de sorte que la seconde entrée (U₋, U₋') est connectée à la borne médiane (m₃) de l'enroulement secondaire respectif (L₂, L₂') par la deuxième impédance (Z₂, Z₂'), dans lequel un nœud de la seconde branche de connexion respective (r2) entre la deuxième impédance (Z₂, Z₂') et la borne médiane (m3) est connecté à la masse par une connexion à la masse (M, M') ;
- la sortie (Uₒᵤₜ, Uₒᵤₜ') est connectée à la seconde extrémité de l'enroulement secondaire respectif (L₂, L₂') par une troisième impédance (Z₃, Z₃').

15. Procédé selon l'une quelconque des revendications 12 à 14, comprenant une étape de prévoir un amplificateur de sortie différentiel (U1) comportant un circuit de sortie (O) pour générer le signal de sortie différentiel (Vₒᵤₜ).
